# EUROPÄISCHE PATENTSCHRIFT

(11) **EP 3 036 761 B1**
(45) Veröffentlichungstag und Bekanntmachung des Hinweises auf die Patenterteilung: **10.07.2019**
(21) Anmeldenummer: 14771823.3
(22) Anmeldetag: 11.09.2014
(51) Int. Cl.: H01L 21/60, H01L 23/488

(54) **VERFAHREN ZUM DIFFUSIONSLÖTEN EINES ELEKTRONISCHEN BAUELEMENTS MIT EINER MONTAGEFLÄCHE MIT VERTIEFUNGEN AUF EINEM SUBSTRAT**
METHOD OF DIFFUSION SOLDERING AN ELECTRONIC COMPONENT WITH A MOUNTING SURFACE WITH RECESSES ON A SUBSTRATE
PROCÉDÉ DE SOUDAGE PAR DIFFUSION D'UN COMPOSANT ÉLECTRONIQUE AVEC UNE SURFACE DE MONTAGE AVEC DES ENFONCEMENTS SUR UN SUBSTRAT

(30) Priorität: 27.09.2013 DE 102013219642
(43) Veröffentlichungstag der Anmeldung: 29.06.2016
(73) Patentinhaber: Siemens Aktiengesellschaft, 80333 München (DE)
(72) Erfinder: STROGIES, Jörg, 14163 Berlin (DE); WILKE, Klaus, 12527 Berlin (DE)
(86) Internationale Anmeldenummer: PCT/EP2014/069368
(87) Internationale Veröffentlichungsnummer: WO 2015/043969

(56) Entgegenhaltungen:
- EP-A1- 1 450 402
- EP-A1- 1 450 402
- WO-A1-2006/060981
- WO-A1-2013/004543
- WO-A1-2013/004543
- DE-A1-102012 105 929
- DE-B3-102005 055 280
- DE-B3-102005 055 280
- DE-T2- 69 428 378
- DE-T2- 69 428 378
- JP-A- H0 738 208
- JP-A- H0 738 208
- JP-A- S6 164 132
- JP-A- 2007 110 001
- US-A1- 2012 306 087
- US-B1- 6 670 222
- LI M ET AL: "Thermodynamic optimization of the Cu-Sn and Cu-Nb-Sn systems", JOURNAL OF ALLOYS AND COMPOUNDS, ELSEVIER SEQUOIA, LAUSANNE, CH, Bd. 477, Nr. 1-2, 17. November 2008 (2008-11-17), Seiten 104-117, XP026086127, ISSN: 0925-8388, DOI: 10.1016/J.JALLCOM.2008.09.141 [gefunden am 2008-11-17]
- "Lot (Metall)", Wikipedia, 10. September 2013 (2013-09-10), XP055165999, Gefunden im Internet: URL:http://de.wikipedia.org/w/index.php?ti tle=Lot_(Metall)&oldid=122411715 [gefunden am 2015-01-29]

## Beschreibung

Die Erfindung betrifft ein Verfahren zum Diffusionslöten eines elektronischen Bauelements auf einem Substrat. Bei diesem Verfahren wird das Bauelement mit seiner Montagefläche auf eine Kontaktfläche des Substrats aufgesetzt, wobei zwischen dem Substrat und dem Bauelement ein Lotwerkstoff zum Einsatz kommt. Dann wird der Lotwerkstoff auf eine Temperatur erwärmt, die einen Diffusionsvorgang zwischen dem Lotwerkstoff und dem Bauelement sowie zwischen dem Lotwerkstoff und dem Substrat in Gang setzt, wobei die Lötverbindung ausgebildet wird. Hierbei diffundieren chemische Elemente aus dem Bauelement und dem Substrat in die sich ausbildende Lötverbindung, wobei sich in dieser die chemische Zusammensetzung ändert. Genau genommen diffundieren die chemischen Elemente aus den hierfür vorgesehenen Metallisierungen in die Lotverbindung. Diese Metallisierungen auf dem Bauelement und dem Substrat werden im Sinne dieser Erfindung als Teile von Bauelement und Substrat aufgefasst.

Vorzugweise wird der Lotwerkstoff verflüssigt, da die Diffusionsvorgänge im Lotwerkstoff hierdurch enorm beschleunigt werden können. Außerdem liegt dann auch eine genügend hohe Temperatur vor, damit die Diffusionsvorgänge in dem Bauelement und dem Substrat ausgelöst werden. Genauer werden diese Diffusionsvorgänge in den Kontaktmaterialien ausgelöst, die die Kontaktfläche und die Montagefläche bilden, wobei diese Kontaktmaterialien im Sinne der Erfindung jeweils als Teil des Bauelements und Teil des Substrats aufzufassen sind.

Die sich ausbildende Lötverbindung weist eine den Zwischenraum zwischen Kontaktfläche und Montagefläche überbrückende Diffusionszone auf. Hierbei handelt es sich um eine Zone, in die das Material aus den Kontaktmaterialien hinein diffundiert ist, so dass sich ein Material ausbildet, welches im Vergleich zum Lotwerkstoff, also dem Ausgangsmaterial, eine erhöhte Schmelztemperatur aufweist. Wenn die Kontaktmaterialien Kupfer enthalten, kann die Diffusionszone bei einem Zinn enthaltenden Lotwerkstoff beispielsweise durch die intermetallische Verbindung zwischen Kupfer und Zinn ausgebildet werden. Diese weist einen Schmelzpunkt von ungefähr 420°C auf, welcher eindeutig über demjenigen zinnbasierter Lotwerkstoffe liegt.

Eine elektrische Baugruppe und ein Verfahren zur Herstellung der Diffusionslötverbindungen in einer solchen elektronischen Baugruppe ist beispielsweise in der DE 10 2012 214 901 A1 beschrieben. Es wird vorgeschlagen, dass sogenannte Halbleiteranordnungen, wie z. B. Halbleiterchips, mit einer Diffusionslotschicht auf einer gesinterten Silberschicht befestigt werden können. Hierbei wird aus einer Silberpaste eine gesinterte Silberschicht hergestellt, auf der das Lot aufgebracht wird. Der Diffusionslötprozess besteht darin, dass es zu einer Diffusion von Material zwischen den beiden Schichten kommt, wodurch sich eine Diffusionszone ausbildet. Zum Zwecke der Ausbildung der Diffusionszone ist daher ein Aufbringen unterschiedlicher Materialien erforderlich, wobei eine Diffusion zwischen diesen Lotmaterialien zur Ausbildung der Diffusionszone beiträgt und so den Lötspalt zwischen den zu lötenden Bauteilen überbrückt.

Gemäß der US 2012/0306087 A1 ist es bekannt, dass eine Montagefläche für ein Bauelement auf einem Substrat am Rand mit einer Rille umgeben werden kann, die überschüssigen Lotwerkstoff im Falle des Ausbildens einer Lötverbindung zwischen dem Bauelement und dem Substrat mittels Diffusionslötens unter Druckanwendung aufnehmen kann.

Die WO 2006/060981 A1 offenbart ein Verfahren zum Verbinden eines Chips mit einem Substrat mittels Diffusionslötens, wobei in der Oberfläche des Substrats Vertiefungen in Form von Kanälen ausgebildet sind, in die beim Diffusionslötprozess die unter der Temperatureinwirkung entstehende Metallschmelze fließt. Nach dem Diffusionslöten enthalten die Vertiefungen während des Diffusionslötens gebildete intermetallische Phasen.

Gemäß der DE 10 2012 105 929 A1 ist es bekannt, dass Montageflächen eines Kontaktbügels mit mehreren Rillen versehen werden können, so dass Lotwerkstoff bei der Ausbildung einer Lötverbindung zwischen dem Kontaktstück und einem Bauelement diese Rillen vollständig ausfüllen kann. Eine Diffusionslötverbindung bildet sich dann nur außerhalb der Rillen.

Außerdem ist es gemäß der JP 2007-110001 bekannt, dass überschüssiger Lotwerkstoff auch aus einer Lötverbindung beim Diffusionslöten herausgedrängt werden kann, wobei die Kontaktfläche auf dem Substrat erhöht ist, so dass der Lotwerkstoff auf der Oberfläche des die Kontaktfläche umgebenden Substrats gelagert werden kann.

Gemäß der JP H07 38208 A kann vorgesehen werden, dass eine Laserdiode auf einem Substrat montiert wird, wobei das Substrat mit mehreren Nuten versehen ist. Auf das Substrat kann zum Zwecke der Montage der Laserdiode beispielsweise ein Lotwerkstoff aufgetragen werden.

Gemäß der DE 694 28 378 T2 kann auch vorgesehen werden, dass bei einer Halbleiteranordnung die beiden Halbleiter, die gefügt werden sollen, über ein Kontaktloch gefügt werden. Dieses Kontaktloch wird mit einer elektrisch leitenden metallischen Plattierung versehen. Es kann teilweise mit Lot ausgefüllt werden, wobei das Lot zur Ausbildung einer Lötverbindung zwischen den Halbleiterbauteilen verantwortlich ist.

Die Aufgabe der Erfindung besteht darin, ein Verfahren zum Diffusionslöten mit mindestens einer diffusionsgelöteten Lötverbindung anzugeben, bei der bzw. bei dem die sich ausbildende Diffusionslötstelle mit kostengünstigen Komponenten und mit großer Zuverlässigkeit im Betrieb hergestellt werden kann.

Diese Aufgabe wird mit dem eingangs angegebenen Verfahren dadurch gelöst, dass erfindungsgemäß, wie in Anspruch 1 definiert, die Montagefläche des Bauelementes oder, in einem nicht zum beanspruchten Gegenstand gehörenden Beispiel, die Kontaktfläche des Substrats mit Vertiefungen versehen sind, die nach dem Ausbilden der Lötverbindung außerhalb der den Zwischenraum zwischen Kontaktfläche und Montagefläche überbrückenden Diffusionszone liegen.

Die Verwendung von Vertiefungen in der Montagefläche, gemäß der beanspruchten Erfindung, oder in der Kontaktfläche, in einem nicht zum beanspruchten Gegenstand gehörenden Beispiel, hat den Vorteil, dass diese Vertiefungen als Pufferraum für Lotwerkstoff zur Verfügung stehen, wenn das Bauelement auf das Substrat aufgesetzt wird. Hierbei muss berücksichtigt werden, dass die Diffusionszone, die sich bei Ausbildung der Lötverbindung an der Grenzfläche der Montagefläche und der Kontaktfläche zum Lotwerkstoff ausbildet, auf einen bestimmten Abstand beschränkt bleibt, da die Elemente aus dem Kontaktmaterial in einer bestimmten Konzentration im Lotwerkstoff vorliegen müssen, damit es zur Ausbildung der Diffusionszone, beispielsweise durch Ausbildung intermetallischer Verbindungen, kommt. Dies bedeutet jedoch, dass bei Vorliegen eines zu großen Spalts die Diffusionszonen, die sich jeweils von der Montagefläche bzw. von der Kontaktfläche ausgehend in der Lötverbindung ausbilden, nicht treffen. Damit entstünde keine den Spalt überbrückende Diffusionszone, die jedoch für die mechanische und thermische Stabilität der Lötverbindung von hervorragender Bedeutung ist. Dem könnte nun begegnet werden, indem, wie im Stand der Technik beschrieben, Schichten mit dem zur Diffusion vorgesehenen Material zwischen denen des Lotwerkstoffs hergestellt werden. Allerdings ist dies mit einem zusätzlichen Fertigungsaufwand verbunden, der gemäß der Aufgabenstellung gerade eingespart werden soll.

Andererseits ist es schwierig, das Lotmaterial so dünn auf die Fügepartner aufzutragen, dass der sich durch den Auftrag an Lotwerkstoff ergebende Spalt hinreichend schmal ist, damit dieser durch die sich ausbildende Diffusionszone überbrückt wird. Hierbei spielen Fertigungstoleranzen eine Rolle, die dazu führen, dass derartig dünne Schichten an Lotwerkstoff nicht überall gleich dick wären und so ein Kontakt in bestimmten Bereichen nicht zustande käme. Hier setzt die Erfindung an, indem die Vertiefungen vorgesehen werden. Hierdurch wird es ermöglicht, dass der Lotwerkstoff in einer genügenden Dicke aufgebracht werden kann, wobei bei Annäherung der Fügepartner (Bauelement und Substrat) überschüssiges Lotmaterial in die Vertiefungen hinein verdrängt wird (dies kann durch Aufprägen einer uniaxialen Fügekraft in Aufsetzrichtung der Bauelementes unterstützt werden). Dabei kommt im Bereich außerhalb der Vertiefungen zwischen der Kontaktfläche und der Montagefläche eine zuverlässige Beaufschlagung mit Lotmaterial zustande. Dabei wird das Bauelement an das Substrat so weit angenähert, dass der sich ergebende Fügespalt hinreichend eng ist, damit eine den Fügespalt (Zwischenraum) überbrückende Diffusionszone durch den Lötprozess ausgebildet wird.

Es ist unerheblich, ob die Vertiefungen, wie beansprucht, in der Montagefläche oder, in einem nicht zum beanspruchten Gegenstand gehörenden Beispiel, in der Kontaktfläche vorgesehen werden. In jedem Fall grenzen die Vertiefungen an den den Fügespalt bildenden Zwischenraum an und können auf diese Weise mit überschüssigem Lotwerkstoff gefüllt werden. Die an die Vertiefungen grenzende Montagefläche bzw. Kontaktfläche können vorzugsweise plan ausgebildet sein. In diesem Fall lassen sich die Montagefläche sowie die Kontaktfläche einfach herstellen und es bildet sich vorteilhaft ein Zwischenraum mit einer einfachen Geometrie aus. Allerdings ist es auch möglich, dass die Montagefläche und/oder die Kontaktfläche gekrümmt vorliegen. In diesem Fall kann der Übergang hin zu den Vertiefungen auch fließend ausgebildet sein. Vertiefungen befinden sich in diesem Fall in den Bereichen, wo der Abstand der Kontaktfläche und der Montagefläche größer ist, während der den Fügespalt bildende Zwischenraum dort vorliegt, wo sich der Abstand zwischen der Montagefläche und der Kontaktfläche so weit verringert, dass dieser durch die Diffusionszone überbrückt werden kann.

Damit überschüssiges Lotmaterial zuverlässig in die Vertiefungen hinein verdrängt wird, kann gemäß einer Ausgestaltung der Erfindung vorgesehen werden, dass der prozentuale Anteil des Flächenbedarfes der Vertiefungen im Verhältnis zum Flächenbedarf der Montagefläche des Bauelementes oder, in einem nicht zum beanspruchten Gegenstand gehörenden Beispiel, der Kontaktfläche des Substrates bei über 50 %, bevorzugt bei über 70 % liegt. Die verbleibende Fläche, die durch die Strukturelemente zur Verfügung gestellt wird, wird so groß gewählt, dass diese zur Ausbildung einer mechanisch stabilen Diffusionslötverbindung noch ausreicht. Gleichzeitig stellten die Vertiefungen einen genügend großes Volumen zur Aufnahme von überschüssigem Lotmaterial zur Verfügung.

Gemäß der Erfindung ist vorgesehen, dass die Vertiefungen die Form von Kanälen haben. Diese können die Flächenelemente der Montagefläche oder, in einem nicht zum beanspruchten Gegenstand gehörenden Beispiel, der Kontaktfläche umgeben oder auch sich kreuzend angeordnet sein. Die Tiefe der Kanäle bestimmt die Menge an Lotwerkstoff, der aufgenommen werden kann. Zu bemerken ist auch, dass die sich ausbildenden Gase während des Lötvorgangs (bedingt durch die Verdampfung von beispielsweise dem Binder des Lotmaterials) über die Kanäle entweichen können. Besonders vorteilhaft ist es, wenn die Kanäle säulenartige Strukturelemente umgeben, wobei die Stirnflächen der Strukturelemente die Montagefläche oder, in einem nicht zum beanspruchten Gegenstand gehörenden Beispiel, die Kontaktfläche für die hochschmelzen Verbindung (Diffusionszone)ausbilden. Die Säulen müssen nicht notwendigerweise einen Kreisquerschnitt aufweisen. Diese können auch mit ovalem oder rechteckigem Querschnitt ausgeführt sein. Der Begriff Säulen ist im Sinne dieser Erfindung also im weitesten Sinne zu verstehen. Die Kanäle müssen keine gleichbleibende Breite haben. Diese können vorzugsweise linear angeordnet werden, wobei dies vorteilhaft eine besonders einfache Fertigung derselben ermöglicht. Die Kanäle können jedoch auch gekrümmt verlaufen oder die säulenartigen Strukturelemente umgeben.

Gemäß einer anderen Ausgestaltung ist vorgesehen, dass der prozentuale Anteil des Flächenbedarfs der Vertiefungen an der Montagefläche oder, in einem nicht zum beanspruchten Gegenstand gehörenden Beispiel, an der Kontaktfläche lokal variiert wird. Hiermit ist gemeint, dass es über die gesamte Fläche gesehen Bereiche gibt, wo die Vertiefungen einen größeren Flächenanteil an der dort lokal vorliegenden Gesamtfläche einnehmen als in anderen Bereichen. Hierdurch kann vorteilhaft die Lötverbindung an die Anforderungen spezifischer Bauelemente angepasst werden, wie im Folgenden näher erläutert werden soll. Beispielsweise ist es gemäß einer besonderen Ausgestaltung der Erfindung möglich, dass der prozentuale Anteil des Flächenbedarfs der Vertiefungen in Bereichen der Montagefläche oder, in einem nicht zum beanspruchten Gegenstand gehörenden Beispiel, an der Kontaktfläche, in denen ein erhöhter Wärmeübergang zu erwarten ist, höher gewählt wird, als in den Bereichen mit einem geringeren zu erwartenden Wärmeübergang. Hiermit kann auf konstruktivem Wege erreicht werden, dass in den Bereichen erhöhter Wärmeentwicklung eines Bauelements auch eine stärkere Wärmeableitung möglich ist. Dies führt zu einem gleichmäßigeren Temperaturprofil des Bauelements, was einerseits die gesamte thermische Belastung des Bauelements verringert und andererseits zu einem gleichmäßigeren Wärmedehnungsverhalten führt. Hierdurch lässt sich vorteilhaft die thermische Bauteilbelastung aufgrund der absoluten Wärmeentwicklung und aufgrund von Wärmespannungen vermindern.

Eine andere Möglichkeit besteht gemäß einer besonderen Ausführung der Erfindung darin, dass der prozentuale Anteil des Flächenbedarfs der Vertiefungen am Rande der Montagefläche oder, in einem nicht zum beanspruchten Gegenstand gehörenden Beispiel, der Kontaktfläche höher gewählt wird, als in der Mitte. Diese Ausführung ermöglicht es vorteilhaft, dass überschüssiges Lotmaterial sowie die beim Löten entstehenden Gase leichter von der Mitte der Lötverbindung nach außen transportiert werden können. Dies verbessert vorteilhaft die Qualität der sich ausbildenden Lötverbindung. Weitere Einzelheiten der Erfindung werden nachfolgend anhand der Zeichnung beschrieben. Gleiche oder sich entsprechende Zeichnungselemente sind in den einzelnen Figuren jeweils mit den gleichen Bezugszeichen versehen und werden nur insoweit mehrfach erläutert, wie sich Unterschiede zwischen den Figuren ergeben. Es zeigen:
- Figur 1: bis 4 ausgewählte Fertigungsschritte eines Ausführungsbeispiels des erfindungsgemäßen Verfahrens,
- Figur 5: eine alternative Ausgestaltung der Lötverbindung gemäß einem nicht zum beanspruchten Gegenstand gehörenden Beispiel einer elektronischen Baugruppe im schematischen Schnitt,
- Figur 6 bis 8: unterschiedliche Verteilungen von Vertiefungen auf Fügeflächen und/oder Kontaktflächen gemäß weiteren Ausführungsbeispielen des erfindungsgemäßen Verfahrens oder gemäß nicht zum beanspruchten Gegenstand gehörenden Beispielen als Aufsicht.

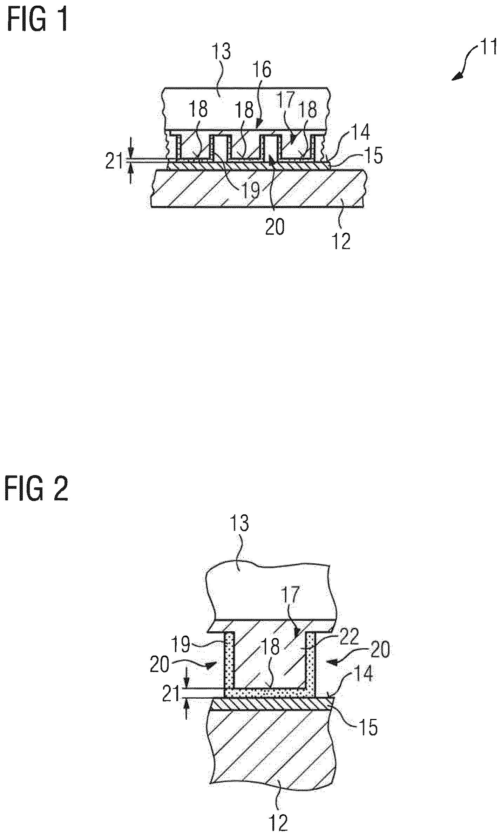

Eine elektronische Baugruppe 11 gemäß Figur 1 weist ein Substrat 12 auf, auf dem ein elektronisches Bauelement 13 befestigt ist. Hierzu stellt das Substrat 12 eine Kontaktfläche 14 zur Verfügung, die aus einer Metallisierung 15 strukturiert wurde. Das Bauelement 13 weist eine Montageseite 16 mit einer Metallstruktur 17 auf, wobei die Metallstruktur 17 eine Montagefläche 18 für eine Lötverbindung zur Verfügung stellt. Zwischen der Montagefläche 18 und der Kontaktfläche 14 ist ein Lotwerkstoff 19 vorgesehen. Die Darstellung gemäß Figur 1 zeigt die elektronische Baugruppe somit vor dem Lötvorgang. Der Figur 1 ist weiterhin zu entnehmen, dass die Montagefläche 18 nicht über die gesamte Fläche mit der Kontaktfläche 14 des Substrats in Verbindung steht. Vielmehr sind zwischen Bereichen der Montagefläche 18 Kanäle 20 vorgesehen, die nicht vollständig mit dem Lotwerkstoff 19 gefüllt sind. Zwar reicht der Lotwerkstoff teilweise in die Kanäle 20 hinein, jedoch ist eine vorläufige Verbindung zwischen dem Substrat 11 und dem Bauelement 13 nur im Bereich der Montagefläche 18 gegeben, wo sich ein Zwischenraum 21 ergibt, der den Fügespalt zum Ausbilden der Diffusionslötverbindung zur Verfügung stellen soll (hierzu im Folgenden noch mehr).

In Figur 2 ist ein säulenartiges Strukturelement 22 dargestellt, welches von Kanälen 20 (wie in Figur 1 dargestellt) umgeben ist. Es handelt sich um einen Ausschnitt einer Anordnung wie in Figur 1 gezeigt. Dabei ist ein Verfahrensstadium für die Ausbildung der Lötverbindung dargestellt, bei dem das Bauelement 13 gerade auf das Substrat 11 aufgesetzt wurde.

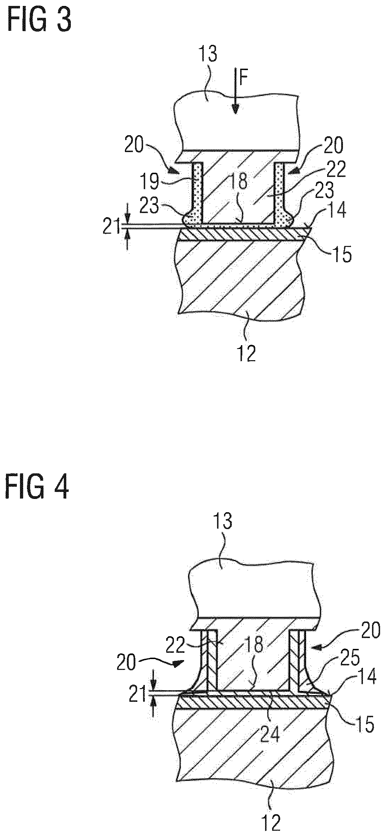

In Figur 3 ist der nächste Fertigungsschritt dargestellt. Es wird eine Montagekraft F auf das Bauelement 13 aufgebracht, was dazu führt, dass sich der Abstand zwischen dem Bauelement 13 und dem Substrat 11 verringert. Dabei verringert sich auch der Zwischenraum 21 zwischen der Kontaktfläche 14 und der Montagefläche 18 bei gleichzeitiger Ausbildung des geforderten Fügespalts. Der Lotwerkstoff 19 wird dabei aus dem Zwischenraum 21 teilweise verdrängt und bildet Wulste in dem Volumen, welches durch die Kanäle 20 zur Verfügung gestellt wird.

In Figur 4 wurde der Fertigungsschritt des Lötens bereits durchgeführt, so dass eine Lötverbindung ausgebildet wurde. Zu erkennen ist, dass diese in direktem Anschluss an die Kontaktfläche 14 und die Montagefläche 18 eine Diffusionszone 24 aufweist, die als intermetallische Verbindung zwischen Kupfer und Zinn ausgebildet ist. Das Kupfer stammt von der Metallisierung 15 und der Metallstruktur 17, die beide aus Kupfer bestehen. Zinn wird durch den Lotwerkstoff 20 zur Verfügung gestellt. Dieser enthält nämlich ein zinnhaltiges Lot, wobei vorteilhaft Standardlotlegierungen zur Verwendung kommen können, welche keine besondere Eignung für das Diffusionslöten aufweisen. Das Lotmaterial kann beispielsweise eine Lotpaste sein, wobei die Lotlegierung, die vorzugsweise bleifrei sein kann (beispielsweise aus Zinn-Silber-Kupfer-Basis) als Partikel einem Bindemittel zugeführt sind. Beim Ausbilden der Lötverbindung schmilzt die Lotlegierung auf und wird durch Eindiffundieren von Kupfer aus der Metallisierung und der Metallstruktur zumindest im angrenzenden Randbereich in seiner chemischen Zusammensetzung so verändert, dass die intermetallische Verbindung in der Diffusionszone 24 entsteht. Der Zwischenraum 21 ist so schmal, dass dieser durch die Diffusionszone 24 zumindest teilweise oder vollständig überbrückt wird. Hier entsteht eine thermisch sehr stabile Bauteilverbindung, da der Schmelzpunkt der intermetallischen Verbindung bei über 400 °C liegt. Außerhalb der Diffusionszone ist zu erkennen, dass sich eine erweiterte Lötverbindung aus der Lotlegierung 25 ausbildet. Diese füllt die Kanäle 20 teilweise aus. Auch die Lotlegierung kann zur Übertragung des elektrischen Stroms herangezogen werden, da sie den Querschnitt des säulenartigen Strukturelements 22 vergrößert.

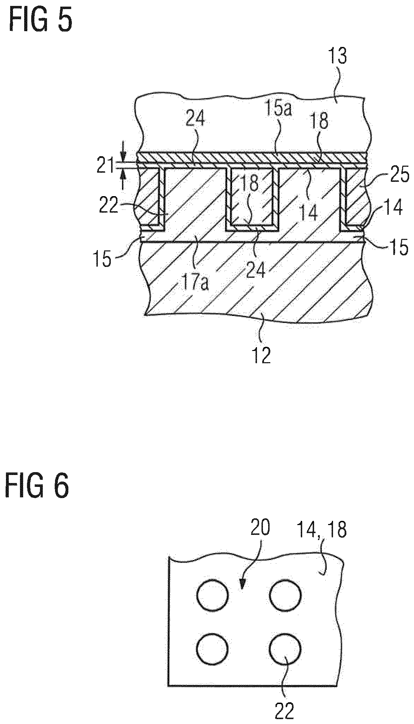

In Figur 5 ist eine andere Bauform der elektrischen Baugruppe als Ausschnitt dargestellt. Auch diese wurde bereits verlötet. Der Unterschied liegt darin, dass eine Metallstruktur 17a nicht am Bauelement 13, sondern auf dem Substrat 12 vorgesehen ist. Dementsprechend ist eine Metallisierung an dem Bauelement 13 vorgesehen. In Figur 5 wird der Zwischenraum analog zu der in den Figuren 1 bis 4 dargestellten Weise durch die Kontaktfläche 14 und die Montagefläche 18 ausgebildet.

Ein weiterer Unterschied im Vergleich zu den Figuren 1 bis 4 liegt darin, dass die Kanäle vollständig mit der Lotlegierung 25 ausgefüllt sind, was jedoch nicht zum beanspruchten Gegenstand gehört. Dies wird dadurch erreicht, dass die Fügepartner oder einer der Fügepartner mit einer Menge an Lotwerkstoff versehen wird (vgl. Figur 1), die ausreicht, dass bei Aufbringen der Montagekraft F gemäß Figur 3 die entstehenden Wulste 23 die Kanäle vollständig ausfüllen. So wird nach Ausbilden der Lötverbindung ein größerer Querschnitt zur Leitung des elektrischen Stroms zur Verfügung gestellt, da die Lotlegierung 25 zur Leitung des elektrischen Stroms ebenfalls zur Verfügung steht. Die mechanische Stabilität der Lötverbindung wird durch die im Zwischenraum 21 ausgebildete Diffusionszone 24 sichergestellt.

Die Figuren 6 bis 8 stellen Aufsichten auf die Kontaktfläche 14 oder die Montagefläche 18 dar. Dies hängt davon ab, ob das elektrische Bauelement 13 gemäß Figur 1 oder das Substrat 12 gemäß Figur 5 die Metallstruktur trägt. Da diese sich aber in beiden Fällen strukturell nicht unterscheiden, kann für beide Fälle jeweils eine Darstellung verwendet werden.

In Figur 6 sind die säulenartigen Strukturelemente 22 gemäß der Figuren 1 bis 5 als Aufsicht dargestellt. Es wird deutlich, dass die Kanäle durch die säulenartigen Strukturelemente 22 umgebenden Zwischenräume gebildet sind.

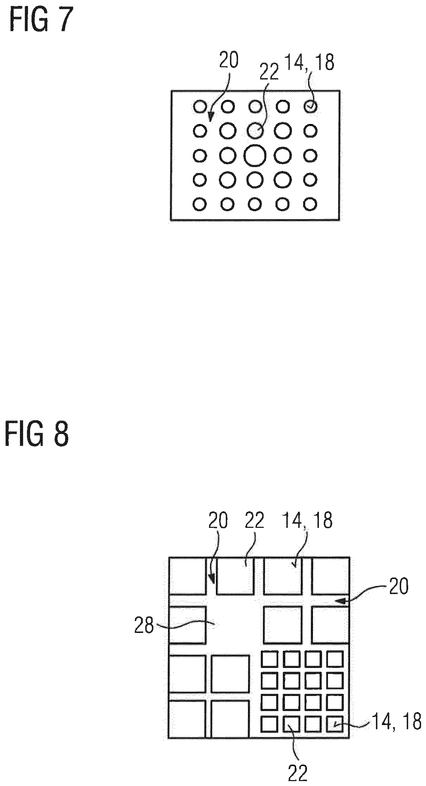

In Figur 7 sind ähnlich wie in Figur 6 säulenartige Strukturelemente dargestellt, welche ebenfalls einen Kreisquerschnitt aufweisen. Die jeweiligen Stirnflächen bilden, wie in Figur 6, die Kontaktfläche 14 oder die Montagefläche 18. Anders als in Figur 6 sind die Durchmesser der säulenartigen Strukturelemente 22 unterschiedlich groß, und zwar der Gestalt, dass der Durchmesser zum Rand der Gruppe der Strukturelemente 22 kleiner wird. Damit wird bei konstanten Säulenabständen das Volumen der die Strukturelemente 22 umgebenden Kanäle 20 zum Rand hin größer, wodurch der Abtransport von überschüssigem Lotwerkstoff vereinfacht wird. Eine solche Bauform ist daher insbesondere für eine Lötverbindung gemäß Figur 5 geeignet, wo die Kanäle 20 vollständig durch die Lotlegierung 25 ausgefüllt werden sollen.

In Figur 8 sind säulenartige Strukturelemente 22 zu erkennen, die einen quadratischen Querschnitt haben. Diese werden durch Kanäle 20 mit flachem Kanalboden voneinander getrennt. Auch in Figur 8 ist zu erkennen, dass in der rechten unteren Ecke gemäß Figur 8 die pro Flächeneinheit zur Verfügung stehende Kontaktfläche 14 bzw. Montagefläche 18 nur halb so groß ist wie im restlichen Bereich, da doppelt so viele der sich kreuzenden Kanäle 22 angeordnet sind. Außerdem ist gemäß Figur 8 auch ein zusätzliches Reservoir 28 zu erkennen, wo kein säulenartiges Strukturelement 22 vorgesehen ist, so dass ein größerer Hohlraum zur Aufnahme von Lotwerkstoff entsteht. Solche Reservoirs können insbesondere dann vorgesehen werden, wenn die Montagefläche 18 bzw. Kontaktfläche 14 besonders groß ist, so dass überschüssiger Lotwerkstoff nicht ohne Weiteres zum Rand dieser Fläche transportiert werden kann.

## Patentansprüche

1. Verfahren zum Diffusionslöten eines elektronischen Bauelementes (13) auf einem Substrat (12), bei dem
- eine Montagefläche (18) des Bauelementes (13) mit Vertiefungen (20) versehen ist, die die Form von Kanälen (20) haben und diese Kanäle (20) säulenartige Strukturelemente (22) umgeben, wobei die Strukturelemente (22) die Montagefläche (18) ausbilden, wobei die Kanäle (20) und die Strukturelemente (22) gemeinsam eine zusammenhängende Metallstruktur (17) ausbilden,
- das Substrat (12) eine aus einer Metallisierung (15) strukturierte, zusammenhängende Kontaktfläche (14) aufweist,
- das Bauelement (13) mit seiner Montagefläche (18) auf die Kontaktfläche (14) des Substrats (12) aufgesetzt wird, wobei zwischen dem Substrat (12) und dem Bauelement (13) ein Lotwerkstoff (19) zum Einsatz kommt, der vor dem Lötvorgang teilweise in die Kanäle (20) hineinreicht, wobei der Lotwerkstoff (19) die Kanäle (20) unvollständig ausfüllt und einen Grund und einen mittleren Bereich eines jeden Kanals (20) freilässt, wobei sich der mittlere Bereich über die gesamte Tiefe des Kanals (20) bis zu seinem Grund erstreckt,
- eine Montagekraft (F) auf das Bauelement (13) aufgebracht wird, was dazu führt, dass sich der Abstand zwischen dem Bauelement (13) und dem Substrat (11) sowie der Zwischenraum (21) zwischen der Kontaktfläche (14) und der Montagefläche (18) verringert, wobei der Lotwerkstoff (19) dabei aus dem Zwischenraum (21) teilweise verdrängt wird und Wulste (23) in dem Volumen bildet, welches durch die Kanäle (20) zur Verfügung gestellt wird,
und
- der Lotwerkstoff (19) auf eine Temperatur erwärmt wird, die einen Diffusionsvorgang zwischen dem Lotwerkstoff (19) und dem Bauelement (13) sowie dem Substrat (12) in Gang setzt, wobei eine Lötverbindung ausgebildet wird, die eine den Zwischenraum (21) zwischen Kontaktfläche (14) und Montagefläche (18) überbrückende Diffusionszone (24) aufweist, die eine im Vergleich zum Lotwerkstoff erhöhte Schmelztemperatur aufweist,
- wobei die Kanäle (20) nach dem Ausbilden der Lötverbindung außerhalb der den Zwischenraum (21) zwischen der Kontaktfläche (14) und der Montagefläche (18) überbrückenden Diffusionszone (24) liegen und außerhalb der Diffusionszone (24) durch eine erweiterte Lötverbindung aus dem Lotwerkstoff nur teilweise ausgefüllt sind.

2. Verfahren nach Anspruch 1, wobei der prozentuale Anteil des Flächenbedarfes der Vertiefungen (20) an der Montagefläche (18) lokal variiert wird.

3. Verfahren nach Anspruch 2, wobei der prozentuale Anteil des Flächenbedarfes der Vertiefungen (20) am Rande der Montagefläche (18) höher gewählt wird, als in der Mitte.

4. Verfahren nach einem der voranstehenden Ansprüche, wobei der prozentuale Anteil des Flächenbedarfes der Vertiefungen (20) im Verhältnis zum Flächenbedarf der Montagefläche (18) des Bauelementes (13) bei über 50 %, bevorzugt bei über 70 % liegt.

## Claims

1. Method for diffusion soldering an electronic component (13) on a substrate (12), in which method
- a mounting surface (18) of the component (13) is provided with recesses (20) which are in the form of channels (20) and these channels (20) surround pillar-like structural elements (22), wherein the structural elements (22) form the mounting surface (18), wherein the channels (20) and the structural elements (22) together form a coherent metal structure (17),
- the substrate (12) has a coherent contact area (14) which is structured from a metallization (15),
- the component (13), by way of its mounting surface (18), is placed onto the contact area (14) of the substrate (12), wherein a soldering material (19) which extends partially into the channels (20) before the soldering process is used between the substrate (12) and the component (13), wherein the soldering material (19) incompletely fills the channels (20) and leaves free a base and a middle region of each channel (20), wherein the middle region extends over the entire depth of the channel (20) as far as its base,
- a mounting force (F) is applied to the component (13), this leading to the distance between the component (13) and the substrate (11) and also the intermediate space (21) between the contact area (14) and the mounting surface (18) being reduced, wherein the soldering material (19) is partially displaced out of the intermediate space (21) and forms beads (23) in the volume which is made available by the channels (20),
and
- the soldering material (19) is heated to a temperature which initiates a diffusion process between the soldering material (19) and the component (13) and also the substrate (12), wherein a soldered connection is formed, which soldered connection has a diffusion zone which bridges the intermediate space (21) between the contact area (14) and the mounting surface (18) and which has an elevated melting point in comparison to the soldering material,
- wherein the channels (20), after the soldered connection is formed, lie outside the diffusion zone (24) which bridges the intermediate space (21) between the contact area (14) and the mounting surface (18) and are only partially filled by an extended soldered connection composed of the soldering material outside the diffusion zone (24).

2. Method according to Claim 1, wherein the percentage of the surface requirement of the recesses (20) on the mounting surface (18) is locally varied.

3. Method according to Claim 2, wherein the percentage of the surface requirement of the recesses (20) at the edge of the mounting surface (18) is selected to be higher than in the middle.

4. Method according to one of the preceding claims, wherein the percentage of the surface requirement of the recesses (20) in relation to the surface requirement of the mounting surface (18) of the component (13) lies at above 50%, preferably at above 70%.

## Revendications

1. Procédé de soudage par diffusion d'un composant (13) électronique sur un substrat (12), dans lequel :
- une surface de montage (18) du composant (13) est pourvue de creux (20) qui ont la forme de canaux (20) et ces canaux (20) entourent des éléments de structure (22) en forme de colonne, dans lequel les éléments de structure (22) forment la surface de montage (18) et les canaux (20) et les éléments de structure (22) forment ensemble une structure métallique (17) cohérente,
- le substrat (12) possède une surface de contact (14) cohérente, structurée constituée d'une métallisation (15),
- le composant (13) est posé avec sa surface de montage (18) sur la surface de contact (14) du substrat (12), dans lequel, entre le substrat (12) et le composant (13), on applique un matériau de soudage (19) qui s'étend en partie à l'intérieur des canaux (20) avant le processus de soudage, lequel matériau de soudage (19) remplit les canaux (20) incomplètement, et laisse libre un fond et une région centrale de chaque canal (20), la région centrale s'étendant sur toute la profondeur du canal jusqu'à son fond,
- une force de montage (F) est appliquée sur le composant (13), ce qui provoque une diminution de l'intervalle entre le composant (13) et le substrat (11) ainsi que de l'intervalle (21) entre la surface de contact (14) et la surface de montage (18), dans lequel le matériau de soudage (19) est ainsi en partie chassé de l'intervalle (21) et forme un bourrelet (23) dans le volume qui est mis à disposition par les canaux (20), et
- le matériau de soudage (19) est réchauffé à une température qui met en route un processus de diffusion entre le matériau de soudage (19) et le composant (13) ainsi que le substrat (12), dans lequel un joint de soudure est formé, lequel comporte une zone de diffusion (24) franchissant l'intervalle (21) entre la surface de contact (14) et la surface de montage (18), qui a une température de fusion plus élevée comparée au matériau de soudage,
dans lequel les canaux (20), après la formation du joint de soudure, sont situés à l'extérieur de la zone de diffusion (24) franchissant l'intervalle (21) entre la surface de contact (14) et la surface de montage (18) et sont remplis uniquement en partie à l'extérieur de la zone de diffusion (24) par un joint de soudure élargi constitué du matériau de soudage.

2. Procédé selon la revendication 1, dans lequel la proportion en pourcentage de surface nécessaire des creux (20) sur la surface de montage (18) varie localement.

3. Procédé selon la revendication 2, dans lequel la proportion en pourcentage de surface nécessaire des creux (20) au bord de la surface de montage (18) est sélectionnée de façon à être plus élevée que dans le milieu.

4. Procédé selon l'une des revendications précédentes, dans lequel la proportion en pourcentage de surface nécessaire des creux (20) par rapport à la surface nécessaire de la surface de montage (18) du composant (13) est supérieure à 50 %, de préférence supérieure à 70 %.
